# EUROPEAN PATENT APPLICATION

(11) **EP 3 297 106 A1**
(43) Date of publication of application: **21.03.2018**
(21) Application number: 17188109.7
(22) Date of filing: 28.08.2017
(51) Int. Cl.: H01S 5/10, H01S 5/12, H01S 5/34, H01S 5/028, H01S 5/22

(54) **QUANTUM CASCADE LASER DEVICE**

(30) Priority: 14.09.2016 JP 2016179140
(71) Applicant: KABUSHIKI KAISHA TOSHIBA, Minato-ku Tokyo 105-8001 (JP)
(72) Inventor: Fukumizu, Hiroyuki, Tokyo, 105-8001 (JP); Kakuno, Tsutomu, Tokyo, 105-8001 (JP)
(74) Representative: Hoffmann Eitle

(57) **Abstract**

A quantum cascade laser device includes a substrate (10), a semiconductor stacked body (20) and a first electrode (30). The semiconductor stacked body (20) includes an active layer (12) and a first clad layer (14). The active layer (12) is configured to emit infrared laser light by an intersubband optical transition. A ridge waveguide is provided in the semiconductor stacked body (20). A distributed feedback region (40) is provided along a first straight line (50). The ridge waveguide extends along the first straight line (50). The first electrode (30) is provided at an upper surface of the distributed feedback region (40). A diffraction grating (14a) is arranged along the first straight line (50). The distributed feedback region (40) includes an increasing region where a length of the diffraction grating (14a) along a direction orthogonal to the first straight line (50) increases from one end portion of the distributed feedback region (40) toward another end portion of the distributed feedback region (40).

## Description

### FIELD

Embodiments described herein relate generally a quantum cascade laser device.

### BACKGROUND

A quantum cascade laser device emits infrared in a wider wavelength range by using the intersubband transition of carriers such as electrons, etc.

The infrared wavelength is determined by the energy level of quantum well layers having a cascade connection. For example, the controllability and reproducibility of the thicknesses of the well layers, the mole ratios of the constituent elements, etc., between wafers can hardly be called sufficient in the case where the thickness of each of the well layers is thin and is 10 nm or less. Therefore, the infrared wavelength may shift from the prescribed range.

### BRIEF DESCRIPTION OF THE DRAWINGS

FIG. 1A is a partial schematic plan view of a quantum cascade laser device according to a first embodiment, and FIG. 1B is a graph describing the temperature distribution along a first straight line;
FIG. 2A is a partially enlarged schematic cross-sectional view along line A-A of the quantum cascade laser device according to the first embodiment, and FIG. 2B is a schematic cross-sectional view along line B-B;
FIG. 3 is a graph of a simulation of the gain dependence for the wavelength at the positions P1, P2, and P3;
FIG. 4A is a schematic plan view of the distributed feedback region of a quantum cascade laser device according to a comparative example, and FIG. 4B is a graph describing the temperature distribution along the first straight line of the distributed feedback region of the quantum cascade laser device according to the comparative example;
FIG. 5 is a graph illustrating the dependence of the peak wavelength on the change ratio of the InGaAs well layer thickness;
FIG. 6 is a graph illustrating simulation results of the gain dependence on the wavelength for the structure illustrated in (Table 1);
FIG. 7A is a schematic plan view illustrating a first modification of the distributed feedback region, and FIG. 7B is a schematic plan view illustrating a second modification of the distributed feedback region; and
FIG. 8A is a partial schematic plan view of a quantum cascade laser device according to a second embodiment, and FIG. 8B is a partial schematic plan view of a quantum cascade laser device according to a third embodiment.

### DETAILED DESCRIPTION

In general, according to one embodiment, a quantum cascade laser device includes a substrate, a semiconductor stacked body and a first electrode. The semiconductor stacked body includes an active layer and a first clad layer. The active layer is provided on the substrate and is configured to emit infrared laser light by an intersubband optical transition. The first clad layer is provided on the active layer. A ridge waveguide is provided in the semiconductor stacked body. A distributed feedback region is provided along a first straight line at an upper surface of the first clad layer. The ridge waveguide extends along the first straight line. The first electrode is provided at an upper surface of the distributed feedback region. A diffraction grating is arranged along the first straight line in the distributed feedback region. The distributed feedback region includes at least one increasing region where a length of the diffraction grating along a direction orthogonal to the first straight line increases from one end portion of the distributed feedback region toward another end portion of the distributed feedback region.

Embodiments of the invention will now be described with reference to the drawings.

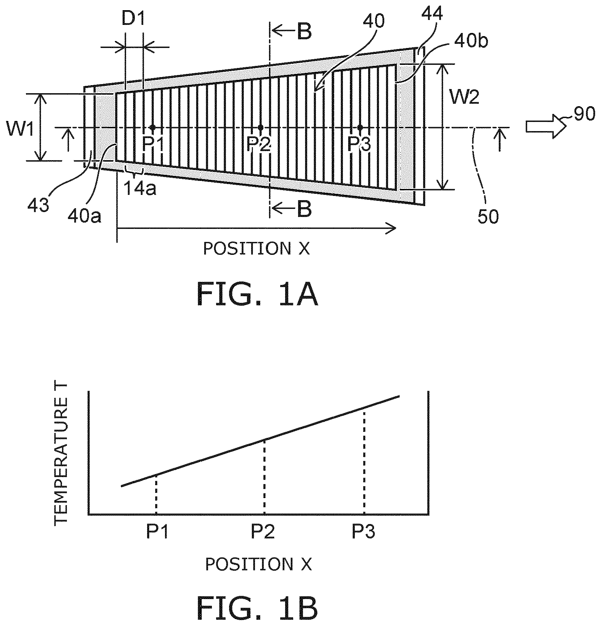

FIG. 1A is a partial schematic plan view of a quantum cascade laser device according to a first embodiment; and FIG. 1B is a graph describing the temperature distribution along a first straight line.

FIG. 1A illustrates the upper surface of a ridge waveguide RG prior to providing a first electrode 30.

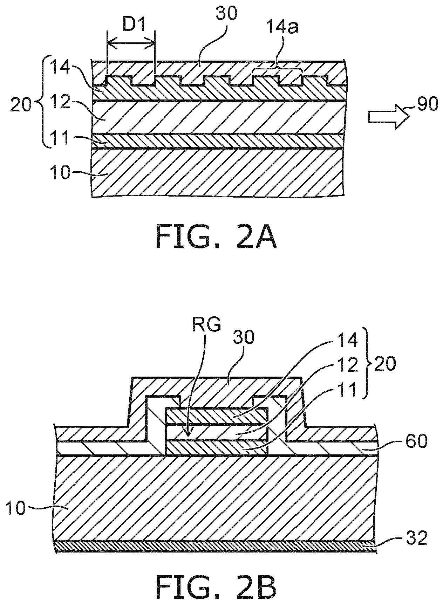

FIG. 2A is a partially enlarged schematic cross-sectional view along line A-A of the quantum cascade laser device according to the first embodiment; and FIG. 2B is a schematic cross-sectional view along line B-B.

As illustrated in FIGS. 2A and 2B, the quantum cascade laser device according to the first embodiment includes a substrate 10, a semiconductor stacked body 20, and the first electrode 30.

The semiconductor stacked body 20 is configured to emit infrared laser light 90 by an intersubband optical transition, includes an active layer 12 provided on the substrate 10, and includes a first clad layer 14 provided on the active layer 12. The ridge waveguide RG is provided in the semiconductor stacked body 20.

A distributed feedback region 40 is provided at the upper surface of the first clad layer 14 along the first straight line (parallel to line A-A) 50 in which the ridge waveguide RG extends. The first electrode 30 is provided at the upper surface of the distributed feedback region 40. A dielectric layer 60 also may be provided at the two side surfaces of the ridge waveguide RG and the upper surface of the substrate 10. In the case where the substrate 10 is conductive, a second electrode 32 may be provided at the back surface of the substrate 10.

As illustrated in FIG. 1A and FIG. 2A, a diffraction grating 14a that has a prescribed pitch D1 is arranged along the first straight line 50 in the distributed feedback region 40. The length of the diffraction grating 14a along a direction orthogonal to the first straight line 50 increases from one end portion 40a of the distributed feedback region 40 toward another end portion 40b of the distributed feedback region 40 along the first straight line 50. For example, the length of the diffraction grating 14a at the one end portion 40a is taken as *W1;* and the length at the another end portion 40b is taken as *W2.*

In other words, in the first embodiment, *W1* < *W2* for the length of the diffraction grating 14a. By setting 1.5*W1* ≤ *W2* ≤ 3*W1*, etc., it is easy to control the temperature distribution while maintaining the horizontal direction beam spread angle in the prescribed range.

FIG. 1B illustrates the dependence of a temperature T of the chip surface on a position X along the first straight line 50. The current that flows in the vertical direction through the active layer 12 increases as the length of the diffraction grating 14a in the direction along line B-B lengthens. Therefore, the generated heat amount is larger as the position X approaches the another end portion 40b than when the position X is at the vicinity of the one end portion 40a. In other words, the temperature distribution can be (the temperature of a position P1) < (the temperature of a position P2) < (the temperature of a position P3).

By providing a highly reflective film 43 at the end surface of the one end portion 40a and by providing a low reflectance film 44 at the another end portion 40b, the infrared laser light 90 is emitted in the right direction of FIG. 2A. However, the infrared laser light 90 is emitted in the left direction in the case where the positions of the two reflective films are reversed.

For example, the trend of the temperature can be reversed by increasing the heat dissipation by providing a buried layer of InP, etc., in the two side-surface directions (parallel to line B-B) of the ridge waveguide RG.

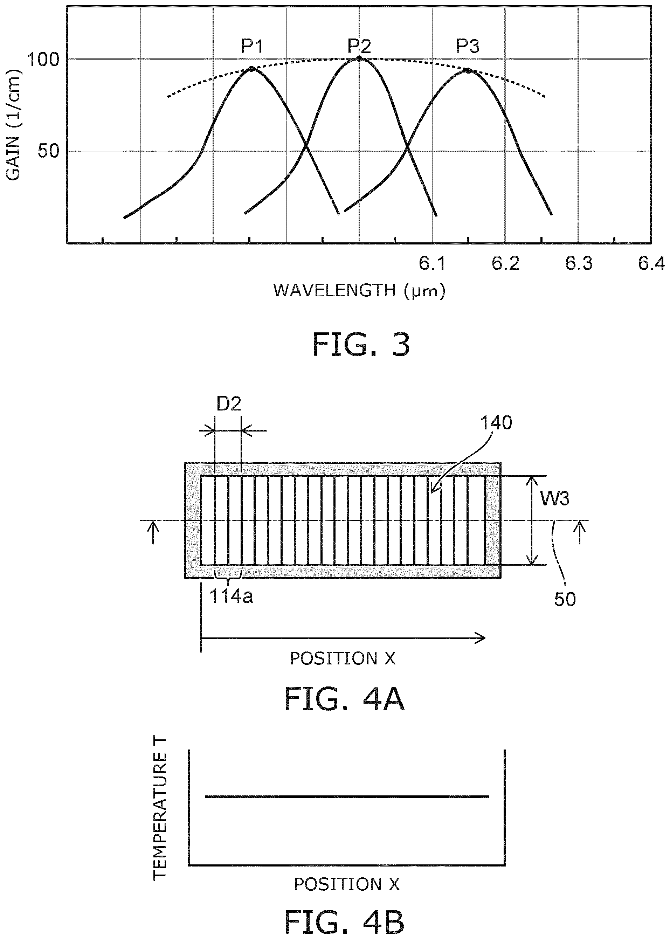

FIG. 3 is a graph of a simulation of the gain dependence for the wavelength at the positions P1, P2, and P3.

The vertical axis is the gain (1/cm); and the horizontal axis is the wavelength (µm). The configuration of the quantum cascade laser device having such a gain dependence is described below.

At the position P1 where the temperature is lowest, the wavelength where the gain has a peak is taken to be about 5.85 µm. At the position P3 where the temperature is highest, the wavelength where the gain has a peak is taken to be about 6.15 µm. At the position P2 of the intermediate temperature, the wavelength where the gain has a peak is taken to be about 6.0 µm. For example, the gain of the active layer at the peak wavelength is taken to be about 100 cm⁻¹. The bandwidth where the gain at each position is 50 cm⁻¹ or more is narrow and is about 0.16 µm.

However, when considering the active layer to be made of three regions having the positions P1, P2, and P3 as centers, the active layer may be considered to include the three gain bandwidths in which the peak wavelengths are about 5.85, 6.0 and 6.15 µm. Actually, there is no boundary between the regions; therefore, the gain dependence on the wavelength has the curve envelope shape illustrated by the broken line.

For example, the bandwidth where the gain is 50 cm⁻¹ or more widens from 5.78 µm to 6.25 µm. However, in the case where the temperature distribution inside the active layer is increased, the peak value of the gain may decrease; and the bandwidth may change.

The temperature dependence of the peak wavelength of the quantum cascade laser device that can oscillate with a single mode due to the distributed feedback region is, for example, 0.5 to 1.0 nm/°C. If the temperature dependence is 1 nm/°C, the peak wavelength at the position P3 can be set to about 200 nm longer than the peak wavelength at the position P1 by setting the temperature at the position P3 to be about 200 °C higher than the temperature at the position P1.

In other words, according to the first embodiment, the gain can effectively have a wide bandwidth by changing the length of the diffraction grating inside the chip and by providing a temperature difference along the first straight line (the direction of the optical axis) 50.

FIG. 4A is a schematic plan view of the distributed feedback region of a quantum cascade laser device according to a comparative example; and FIG. 4B is a graph describing the temperature distribution along the first straight line of the distributed feedback region of the quantum cascade laser device according to the comparative example.

In the comparative example, a length W3 of a diffraction grating 114a is taken to be uniform. Because the generated heat is substantially uniform along the first straight line 50, the change of the temperature at the position X along the first straight line 50 is nearly flat. Therefore, the gain bandwidth is narrow compared to that of the first embodiment.

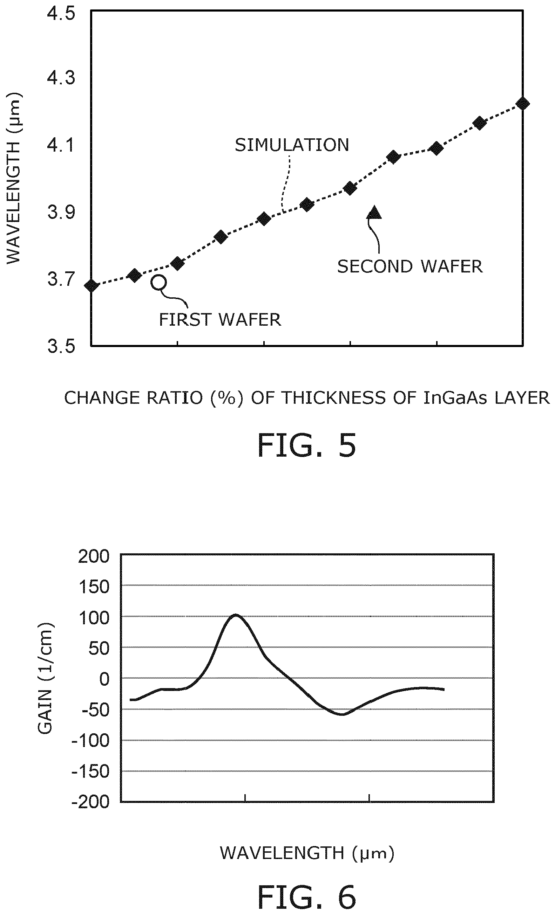

FIG. 5 is a graph illustrating the dependence of the peak wavelength on the change ratio of the InGaAs well layer thickness.

According to the simulation illustrated by the ◆ symbols, the peak wavelength lengthens as the change ratio of the well layer thickness changes from the negative side to the positive side. The peak wavelength average value of a first wafer in which the target value of the well layer thickness is set to minus 7% with respect to the reference thickness of the InGaAs well layer is about 3.7 µm (the ○ symbol). The peak wavelength average value of a second wafer in which the target value of the well layer thickness is set to plus 3% with respect to the reference thickness of the InGaAs well layer is about 3.9 µm (the ▲ symbol). The wavelength difference is large and is about 0.2 µm.

For actual crystal growth processes that use MBE (Molecular Beam Epitaxy) and/or MOCVD (Metal Organic Chemical Vapor Deposition), the peak wavelength difference between wafers is about this level. In the case where a single-mode operation is performed using the diffraction grating, it is not easy to set the gain bandwidth of the active layer to be wider than 0.2 µm.

The desired intersubband optical transition does not occur if the set single-mode wavelength is outside the gain bandwidth of the active layer. In other words, the manufacturing yield of the laser element having the desired peak wavelength decreases.

An example of the quantum well structure of the quantum cascade laser device according to the first embodiment (Table 1) will now be described.

**[Table 1]**

| LAYER | MATERIAL | FILM THICKNESS (nm) |
|---|---|---|
| INJECTION BARRIER LAYER | In_{0.52}Al_{0.48}As | 3.8 |
| LIGHT-EMITTING REGION | In_{0.53}Ga_{0.47}As | 2.1 |
| | In_{0.52}Al_{0.48}As | 0.7 |
| | In_{0.53}Ga_{0.47}As | 6.4 (W1) |
| | In_{0.52}Al_{0.48}As | 1.2 |
| | In_{0.53}Ga_{0.47}As | 5.1 |
| | In_{0.52}Al_{0.48}As | 1.4 |
| | In_{0.53}Ga_{0.47}As | 5.1 |
| EXTRACTION BARRIER LAYER | In_{0.52}Al_{0.48}As | 1.9 |
| ELECTRON INJECTION REGION | In_{0.53}Ga_{0.47}As | 3.9 |
| | In_{0.52}Al_{0.48}As | 1.3 |
| | In_{0.53}Ga_{0.47}As | 3.8 |
| | In_{0.52}Al_{0.48}As | 1.2 |
| | In_{0.53}Ga_{0.47}As | 4.2 |
| | In_{0.52}Al_{0.48}As | 1.9 |
| | In_{0.53}Ga_{0.47}As | 2.4 |
| | In_{0.52}Al_{0.48}As | 2.3 |
| | In_{0.53}Ga_{0.47}As | 2.8 |
| | In_{0.52}Al_{0.48}As | 2.3 |
| | In_{0.53}Ga_{0.47}As | 3.2 |
| | In_{0.52}Al_{0.48}As | 3.0 |
| | In_{0.53}Ga_{0.47}As | 2.5 |
| | In_{0.52}Al_{0.48}As | 3.0 |
| | In_{0.53}Ga_{0.47}As | 2.5 |

The unit quantum well layer includes an injection barrier layer, a light-emitting region, an extraction barrier layer, and an electron injection region. The light-emitting region includes four well layers made of In_{0.53}Ga_{0.47}As and barrier layers made of In_{0.52}Al_{0.48}As that are stacked alternately. The electron injection region that is provided with an extraction barrier layer interposed includes eight well layers made of In_{0.53}Ga_{0.47}As and barrier layers made of In_{0.52}Al_{0.48}As that are stacked alternately. For example, several ten to several hundred layers of this unit quantum well layer are connected by a cascade connection.

FIG. 6 is a graph illustrating simulation results of the gain dependence on the wavelength for the structure illustrated in (Table 1).

The vertical axis is the gain (1/cm); and the horizontal axis is the wavelength (µm). The length of the diffraction grating is the same. The gain has a peak value of about 100 cm⁻¹ when the wavelength is 6.0 µm. The bandwidth where the gain is about 1/2, i.e., 50 cm⁻¹, is about 0.15 µm.

The gain is 0 or less when the wavelength is about 5.8 µm or less and the wavelength is 6.15 µm or more. In other words, in the case where the length of the diffraction grating is set to be uniform, the gain bandwidth is 0.15 µm and is narrow. For example, the peak wavelength of the gain can be changed by changing the thickness W1 of the well layer included in the light-emitting region.

Conversely, in the first embodiment, the gain bandwidth inside the active layer is widened by increasing the temperature distribution. In other words, as illustrated in FIG. 3, the gain bandwidth inside the active layer can be effectively widened; and single-mode laser light of the desired wavelength can be emitted reliably. As a result, the laser element yield can be maintained to be high even in the case where fluctuation of the film thickness and the composition of the active layer occur in the crystal growth processes.

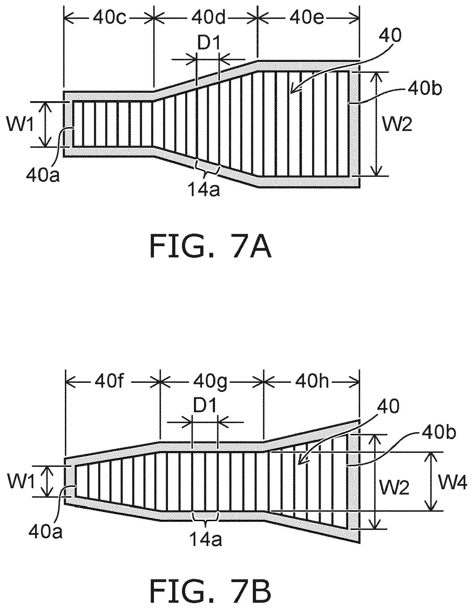

FIG. 7A is a schematic plan view illustrating a first modification of the distributed feedback region; and FIG. 7B is a schematic plan view illustrating a second modification of the distributed feedback region.

As illustrated in FIG. 7A, the distributed feedback region 40 may include a region 40c where the length is *W1,* a region 40e where the length is *W2* (> *W1*), and a region 40d interposed between the region 40c and the region 40e where the length increases monotonously.

As illustrated in FIG. 7B, a region 40f where the length increases monotonously from *W1* to *W4,* a region 40g where the length is *W4,* and a region 40h where the length increases monotonously from *W4* to *W2* may be included.

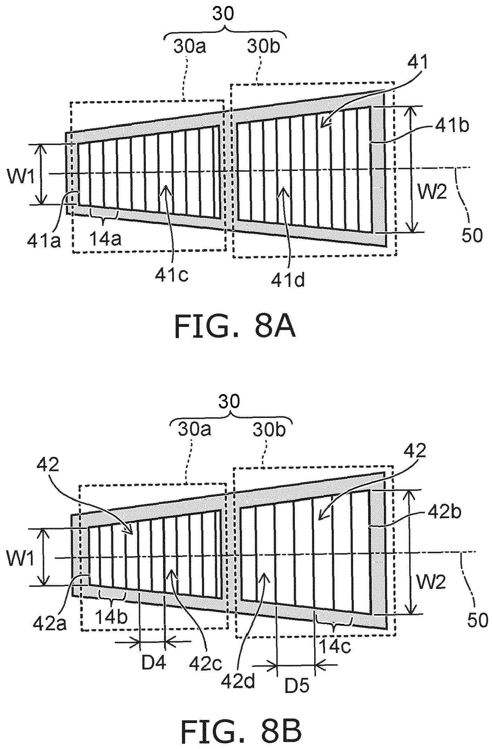

FIG. 8A is a partial schematic plan view of a quantum cascade laser device according to a second embodiment; and FIG. 8B is a partial schematic plan view of a quantum cascade laser device according to a third embodiment.

As illustrated in FIG. 8A, a distributed feedback region 41 includes a region 41c on one end portion 41a side, and a region 41d on another end portion 41b side. The first electrode 30 includes a first region 30a on the region 41c, and a second region 30b on the region 41d. For example, the temperature of the region 41d can be increased further by increasing the current density by setting the applied voltage of the second region 30b of the first electrode 30 to be higher than the applied voltage of the first region 30a of the first electrode 30. As a result, the gain bandwidth of the active layer can be widened further.

As illustrated in FIG. 8B, a distributed feedback region 42 includes a region 42c on one end portion 42a side, and a region 42d on another end portion 42b side. A pitch D4 of a diffraction grating 14b provided in the region 42c is smaller than a pitch D5 of a diffraction grating 14c provided in the region 42d. The first electrode 30 may be subdivided between the first region 30a on the region 42c and the second region 30b on the region 42d or may be provided as the same electrode. By setting the pitches D4 and D5 of the diffraction gratings to be different, the wavelength corresponding to the pitch D4 and the wavelength corresponding to the pitch D5 can be selected. Therefore, the gain bandwidth of the active layer can be widened further.

According to the embodiments of the invention, a quantum cascade laser device is provided in which the controllability and the reproducibility of the light emission wavelength are increased. These quantum cascade laser devices can be used widely in various gas analyzers, detectors of designated substances, etc.

While certain embodiments have been described, these embodiments have been presented by way of example only, and are not intended to limit the scope of the inventions as claimed. Indeed, the novel embodiments described herein may be embodied in a variety of other forms; furthermore, various omissions, substitutions and changes in the form of the embodiments described herein may be made without departing from the scope of the inventions as claimed. The accompanying claims and their equivalents are intended to cover such forms or modification as would fall within the scope of the inventions as claimed.

## Claims

1. A quantum cascade laser device, comprising:
a substrate (10);
a semiconductor stacked body (20) including an active layer (12) and a first clad layer (14), the active layer (12) being provided on the substrate (10) and being configured to emit infrared laser light by an intersubband optical transition, the first clad layer (14) being provided on the active layer (12), a ridge waveguide being provided in the semiconductor stacked body (20), a distributed feedback region (40) being provided along a first straight line (50) at an upper surface of the first clad layer (14), the ridge waveguide extending along the first straight line (50); and
a first electrode(30) provided at an upper surface of the distributed feedback region (40),
a diffraction grating (14a) being arranged along the first straight line (50) in the distributed feedback region (40),
the distributed feedback region (40) including at least one increasing region where a length of the diffraction grating (14a) along a direction orthogonal to the first straight line (50) increases from one end portion (40a) of the distributed feedback region (40) toward another end portion (40b) of the distributed feedback region.

2. The device according to claim 1, wherein
the diffraction grating (14a) has a prescribed pitch, and
the distributed feedback region (40) includes one increasing region that is disposed over the entire surface of the upper surface of the first clad layer (14).

3. The device according to claim 1, wherein
the diffracting grating (14a) has a prescribed pitch, and
the distributed feedback region (40) includes a first increasing region (40f) adjacent to the one end portion (40a) and a second increasing region (40h) adjacent to the another end portion (40b).

4. The device according to claim 1, wherein
the diffracting grating (14a) has a prescribed pitch, and
the distributed feedback region (40) includes one increasing region (40d) provided to be separated from the one end portion (40a) and the another end portion (40b), respectively.

5. The device according to claim 1, wherein
the distributed feedback region (40) includes a first feedback region (41c) provided on a side of the one end portion (40b) of the distributed feedback region (40) and a second feedback region (41d) provided on a side of the another end portion (40b) of the distributed feedback region (40).

6. The device according to claim 1 or 2, wherein
the first electrode (30) includes a first region (30a) provided on a side of the one end portion (40a) of the distributed feedback region (40) and a second region (30b) provided on the another end portion (40b) of the distributed feedback region (40), and
voltages are suppliable independently to the first region and the second region.

7. The device according to claim 1 or 2, wherein
the distributed feedback region (40) includes a first feedback region provided on a side of the one end portion (40a) of the distributed feedback region (40) and a second feedback region provided on a side of the another end portion (40b) of the distributed feedback region (40),
the first electrode (30) includes a first region (30a) provided on the first feedback region and a second region (30b) provided on the second feedback region, and
voltages are suppliable independently to the first region and the second region.

8. The device according to one of claims 1-7, wherein a pitch of a grating of the first feedback region is smaller than a pitch of the second feedback region.

9. The device according to one of claims 1-8, wherein a unit stacked body is multiply stacked in the active layer (12), the unit stacked body including a light-emitting region and an electron injection region, the light-emitting region being made of a multiple quantum well layer, the electron injection region being made of a multiple quantum well layer.

10. The device according to claim 9, wherein the multiple quantum well layer of the light-emitting region and the multiple quantum well layer of the electron injection region each include a well layer made of InGaAs and a barrier layer made of InAlAs.
